# EUROPEAN PATENT APPLICATION

(11) **EP 1 553 500 A1**
(43) Date of publication of application: **13.07.2005**
(21) Application number: 04000100.0
(22) Date of filing: 07.01.2004
(51) Int. Cl.: G06F 13/16, G11C 7/00

(54) **Method and apparatus for indication of valid data**

(71) Applicant: DEUTSCHE THOMSON-BRANDT GMBH, 78048 Villingen-Schwenningen (DE)
(72) Inventor: Drexler, Michael, 30989 Gehrden (DE)
(74) Representative: Rittner, Karsten, Dr.

(57) **Abstract**

When in a digital electronic circuitry a central memory block (MM) is connected to two or more other HW blocks (H1,H2,H3,P), a time-multiplexing mechanism is used for controlling which HW block may access the central memory block. If an interface of such a HW block contains no data_valid signal for read accesses, a data requesting block may detect directly from the read data word if it is valid or not. The method for indicating read data being valid, when the data response time of the memory module is not known, comprises writing a default value on the data bus when the read data are not yet valid, writing the requested data on the data bus when the read data are valid, waiting for a specified time or a specified event, and writing the default value on the bus again.

## Description

### Field of the invention

This invention relates to a method for indicating valid data. Particularly, the invention relates to a method for indicating data being valid, wherein the data are requested by a processor and read from a memory module.

### Background

When in a digital electronic circuitry a central memory block is connected to two or more other hardware (HW) blocks, sending data to or receiving data from these other HW blocks, then this requires usually a mechanism in order to control which HW block may access the central memory block at a certain time. Often time-multiplexing according to a fixed or flexible schedule is used. It depends on the requirements from all the connected HW blocks if a fixed or a flexible time-multiplexing schedule is used. When the time-multiplexing schedule is partly or fully flexible, the HW blocks may need a notification when their requested read or write access is ready. The notification is often a kind of "data valid" or "ready" signal delivered by the central memory block. Normally, a HW block that requested data to be read from such a central memory block has to wait for this notification, and therefore polls, i.e. repeatedly reads the notification signal. This reduces the performance of the requesting block, since it is waiting in an idle state. Further, the central memory block often stores the respective notification in a separate status information register, so that the requesting block has to read the status information register in every poll cycle of a request. Further, a write access is commonly required for transferring a read address to the central memory block. This requires at least five accesses, namely a write access to transfer the data address, a write access to transfer the status information register address, a read access to the status information register, after an evaluation of the result a write access to transfer the data address again, and finally a read access to get the read data.

Particularly when several HW blocks may access a central memory block, time-multiplexing schedules are usually optimized such that the time-slot for each block is as short as possible. Often there are only few accesses per timeslot allowed. Therefore, depending on the number and characteristics or priorities of HW blocks to be served in parallel, a requesting HW block may have to wait several timeslots until it can access the central block again. A maximum time between successive accesses however is usually known.

Particularly when a processor that reads data from a memory block is faster than the memory block can deliver the data, the common solution for the processor is to use wait cycles, which is inflexible and slows down the performance of the processor. Therefore it is desirable to minimize the number of such wait cycles.

One known solution for such a problem is a HW signal, e.g. an additional wait signal between the processor and the hardware, which stops the processor until the hardware data is valid. However, not all processors neither all memory blocks provide such signal.

### Summary of the Invention

Therefore the problem to be solved by the present invention is to provide an improved method for indicating data being valid, wherein an electronic circuitry reads the data from a memory block, and wherein a data bus connects the electronic circuitry and the memory block, and optionally also other blocks that access at least the memory block.

Such method is disclosed in claim 1. A memory module that utilizes the method is disclosed in claim 6.

According to the invention, the memory block uses the data on the data bus to indicate the status of the read data. Therefore the reading circuitry can recognize directly from the read data if this data is valid read data or not. If e.g. the read access after an address write access was too fast, so that the read data is not valid, the read access must be repeated. Advantageously, no additional connection for "wait" signalling between the reading circuitry and the central memory block is required. Instead, the central memory block assigns a default value to the data bus during the time period from specification of the requested data until these data are ready, and optionally also when no data are requested. When the requested data are ready, the memory block assigns these data on the bus. When the requesting circuitry has read the requested and valid data, the memory block continues to write the default value on the bus.

A memory module according to the invention provides an interface for connecting a first circuitry, wherein the interface is suitable for requesting data from the memory module and for providing data via a data bus to the first circuitry. Further, the time between a data request and the requested data being valid on the data bus is not exactly predetermined, and therefore the memory module indicates the requested data being valid, using means for writing a default value on the data bus when the read data are not yet valid, means for writing the requested data on the data bus when the read data are valid, means for measuring a specified time or for triggering on a specified event, and means for writing the default value on the bus again upon expiration of the specified time or upon triggering on the specified event, i.e. when the first circuitry has read the requested and valid data. It is also possible to write the default value on the bus not immediately after detecting such an event, but to wait a specified time after triggering on a specified event before writing the default value on the bus, thus giving the requesting block more time to read the data.

The requesting circuitry or HW block may detect that data are not valid when it receives the default value, and send another read request until it receives another value. Preferably the default value is selected not to be a valid data word. But this is not always possible, so that the default value may be a valid data word, and the requesting HW block receives this default value. In this case it is unknown if the value represents the default or the read data word, and therefore the read value is unreliable until the maximum possible read access time is over. For both synchronous and asynchronous interfaces this situation may be handled by reading the read value repeatedly in all available time slots until the maximum possible read access time is over. If the value remains constant, it must have been a read data word. If the requested data word is different, it will appear on the data bus before the maximum possible read access time.

With the described method, the number of accesses to the central memory block is reduced. For a data read access with individual addressing, the inventive method requires only at least two accesses, namely a write access to transfer the data address, and a read access to get the read data. If the read access was too early and the default data word was read from the data bus, one or more further read accesses may follow immediately without prior addressing, depending on the duration of the requesting HW blocks time slot.

When the central memory block has the read data ready, it assigns to the data bus the read data instead of the default data. The read data may remain to be assigned to the data bus until the central memory block recognizes that the requesting block has received the data, e.g. by an acknowledge or request signal from the requesting HW block. Alternatively, the read data may remain to be assigned to the data bus for a predetermined time, e.g. depending on the access time schedule of the requesting block, so that the requesting block can securely receive the data. As an example, if the requesting block checks the data bus value at least every fifth clock cycle after writing the read address, and the central memory block can deliver the data in the seventh cycle after the address was written, then the requesting block will read the value after another three cycles latest, and afterwards the default value may be assigned to the data bus again.

Advantageous embodiments of the invention are disclosed in the dependent claims, the following description and the figures.

### Brief description of the drawings

Exemplary embodiments of the invention are described with reference to the accompanying drawings, which show in
Fig.1 the structure of an electronic circuit comprising a central memory block, a processor and other HW blocks;
Fig.2 the structure of a memory block being accessible by multiple other blocks;
Fig.3 an exemplary timing diagram of a general memory read operation; and
Fig.4 an exemplary timing diagram of a memory read operation, where the data word is equal to the default data word.

### Detailed description of the invention

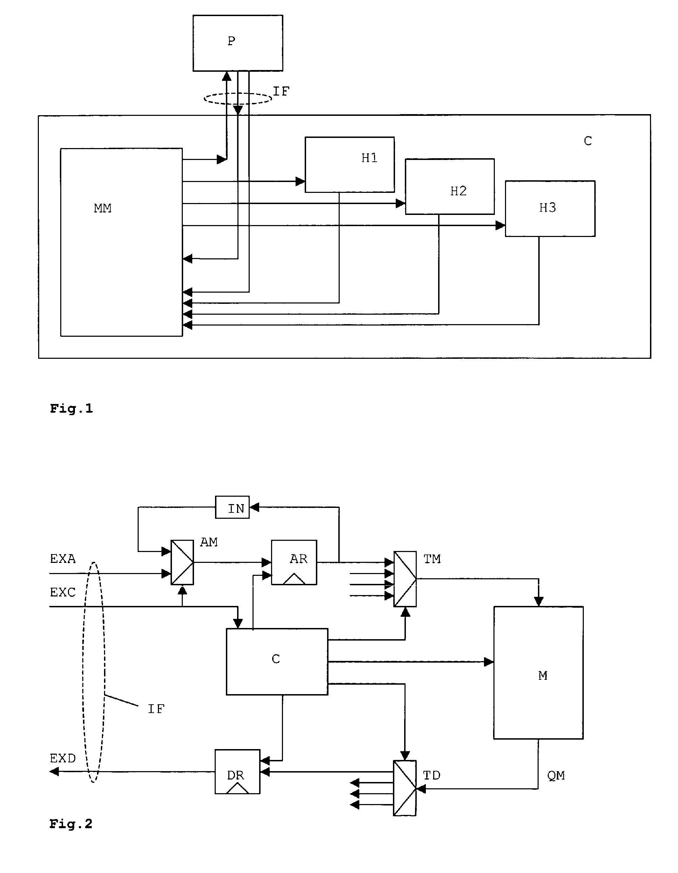

In a first embodiment shown in Fig.1, a processor P and several HW blocks H1,H2,H3 may access a central memory module MM. The HW blocks H1,H2,H3 and the memory module MM are physically implemented on the same chip C, and the processor P is connected via an interface IF to the chip C. The memory module MM has to serve requests from all connected HW blocks H1,H2,H3 and the processor P. But while its interface to the HW blocks H1,H2,H3 is internal within the chip C and may therefore be optimized, e.g. in terms of protocol, timing, schedule etc., the interface IF to the processor P is external. It may be advantageous for several different applications of the chip C if several types of processors can be connected, including processors that accept no "data valid" signal. In this case the processor, by using the inventive method, may detect directly from the received data if they are valid or not. As long as the default value is received and the maximum possible access time is not over, the processor repeats its read accesses, without further address switching e.g. to a status register.

The inventive method is particularly useful when the processor could process the read data faster than the memory block can deliver the data.

The memory module MM is shown in more detail in Fig.2. It contains a chip internal memory element M being accessible from four other blocks using a timeslot schedule. Therefore a time-slot controlled multiplexer TM, a time-slot controlled demultiplexer TD and a control block C are included that are used for switching between the connected blocks. While the other HW blocks H1,H2,H3 may be directly connected to the multiplexer TM and demultiplexer TD, the processor is connected to the multiplexer TM and the demultiplexer TD via an external interface IF, comprising an external address bus input EXA, an external control bus input EXC and an external data bus output EXD. The processor P may access the memory element M by writing to an address register AR and reading from a data register DR that stores the read data for the processor. Additional synchronization stages may be required but are not shown here. A read access is performed by writing the requested memory address via the address bus EXA to the address register AR, indicating via a control signal EXC that the address is valid, and then reading via the data bus EXD the memory data from the data register DR. Internally, the memory element M may receive control signals from the control block C, and send its data via an internal output bus QM and the demultiplexer TD to the data register DR. Further, an address multiplexer AM and an increment counter IN are included for automatically incrementing the memory address, to simplify access to consecutive memory addresses. Because of the timeslot based memory access algorithm, it takes several clock cycles until the read data in the data register DR are valid. E.g. it is possible that it can take up to four clock cycles from writing the memory address to the address register AR until the read data are valid in the data register DR. If the processor read access is faster, it will read a default value, which is inserted into the data register DR by the control block C whenever a control signal EXC or the value in the address register AR changes. The processor P can recognize the read default value to be invalid data without reading additional status information.

In one embodiment of the invention, invalid data may be detected from a single bit on the external data bus EXD. This is e.g. possible if there is an unused bit inside the data register DR, e.g. the memory output QM and therefore the read data has 16 bit while the data register DR has 17 bit. This bit is reset with each new value of the address register AR, and stays reset until the data in the data register DR is valid. Setting the bit signals valid data to the processor P. Then the processor is able to recognize from the data itself if it is valid or not. If the read data is not valid, the access may be repeated until data is valid. As another example, the read data word may contain a parity bit, and while all valid data words have e.g. even parity, the default data word has odd parity, and can thus easily be detected. Since the control block C and the data register DR do the handling of this bit, the parity bit can still be used for memory internal data checks within the memory module M.

In another embodiment of the invention all bits of the data bus EXD are used for data, but the data range comprises an unused value, e.g. 0000ₕₑₓ, which may then be used as default data word to signal invalid data.

In another embodiment of the invention the whole data range and all bits of the data bus EXD are used for the data. According to the invention, a fixed data pattern is used. Advantageously a data pattern is used which occurs rarely, e.g. 0xDEAD.BEEF. Such data pattern may be arbitrarily guessed, or may be found by a statistical analysis of the data. This data pattern is written to the data register DR with each new address at the address register AR. When the read data becomes valid, it overwrites the data pattern in the data register DR. To distinguish between real data having the same value than the data pattern and the data pattern itself, it is possible for the processor to read additional status information. E.g. if the processor reads the default data pattern, it may poll the status information register until "data valid" is signaled, and then repeats reading the data. This is the only case of performance loss.

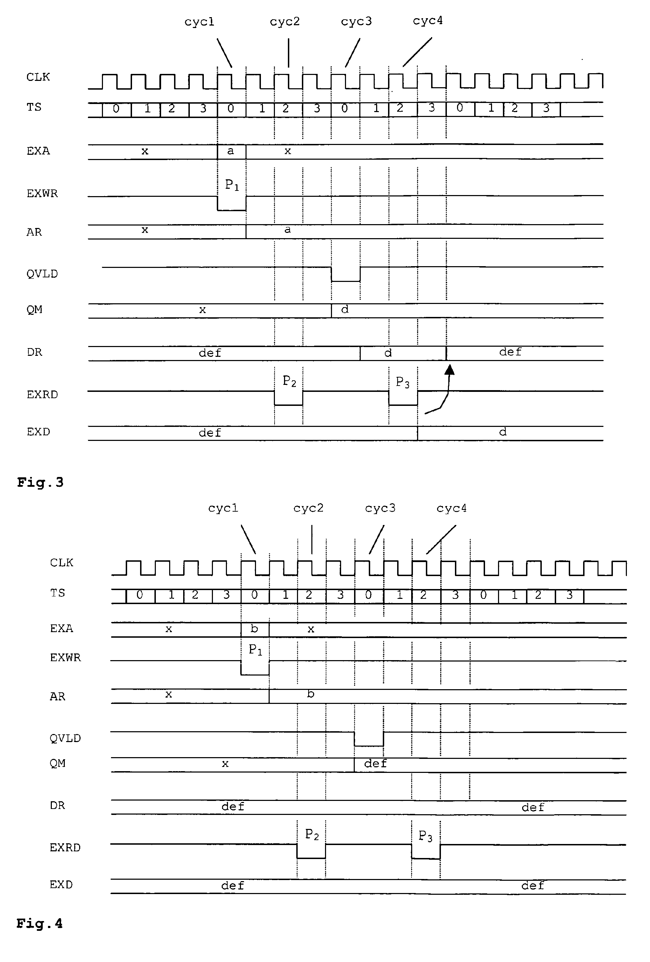

Fig.3 shows a simplified timing diagram of a synchronous circuitry using the inventive method. A processor sends in a dedicated clock cycle *cyc1*, marked e.g. by a timeslot *TS* being 0, an address write request to a memory module, the write request consisting of an address value *a* on an external address bus *EXA* and a write enable pulse *P*_{*1*} on an external write signal *EXWR*. The address value *a* is written into the address register *AR.* Shortly afterwards, in clock cycle *cyc2*, which may be coupled to a timeslot *TS* being 2, the processor sends a read request pulse *P*_{*2*} on the external read request bus *EXRD*, so that a read access is applied to the actual memory. For simplicity, it is assumed here that this read access is applied already in the next cycle.

Generally, this time may vary or be unknown, e.g. if the memory module may be accessed only at specific time slots. Therefore the memory module does not immediately provide the read value on its output *QM*. Thus the processor reads the default value def from the data register *DR* via the external data bus *EXD*, and detects that the read data are not yet valid. Upon that detection, the processor performs another read access in the next clock cycle *cyc4* by sending another read pulse *P*_{*3*}. In the meantime, however, the memory has transmitted the requested data d in clock cycle *cyc3* to the data register *DR,* so that the processor now reads the correct value *d*. The memory module may detect that the read pulse *P*_{*3*} was received while the data register held the correct value, and therefore it can be assumed that the processor has read the correct data. However, it is also possible here to perform a more detailed timing analysis. Upon detecting that the processor has read the data, the default value *def* is assigned again to the data register and thus the external data bus, preferably before the processor can access again.

Another possibility for finding out if the read data are valid without reading a status information register comprises reading several times at the same memory address if the default data pattern was received. If the value does not change within a specified time, the default data pattern itself is the valid data word. This is shown in Fig.4. After writing an address *b* to the address register, a read request P₂ is performed too early and the processor reads the default value *def*, as described above. In this case, however, the data word *def* coming from the memory module *QM* is identical to the default data word. After the processor detected that it received the default data word after its first read access, it performs another read request P₃. As a result, it receives the same value again. The processor can repeat this until the maximum possible read access time has passed. Assuming that this is the case in cycle *cyc4,* the processor can therefore interpret the received data *def* as the actual read data word.

With the proposed scheme, the software speed needs not be adopted to hardware latency, e.g. by hardware means or constant software delay like wait cycles. Only the minimal necessary delay, caused by hardware latency, slows down the read access.

The preferred embodiment of the invention comprises a memory and a related interface block, wherein both may be on a microchip, and wherein the interface block can be connected to an external processor, so that the processor may read data from the memory via the interface block.

Additionally, the interface block may also offer other operations such as e.g. writing data to the memory.

The invention can be used in all electronic devices with memories that are shared between different accessing HW blocks, wherein at least one of the HW blocks is connected via an interface that does not provide a data_valid signal.

## Claims

1. Method for indicating data being valid, the data being requested by a first circuitry and being read from a memory module via a data bus connecting the memory module and the first circuitry, and wherein the data response time of the memory module is not predetermined, the data response time being the time between a data request and the requested data being valid on the data bus, the method comprising the steps of
- writing a default value on the data bus when the read data are not yet valid;
- writing the requested data on the data bus when the read data are valid;
- waiting for a specified time or a specified event; and
- writing the default value on the bus.

2. Method according to claim 1, wherein the specified event is a change in a signal received from the first circuitry.

3. Method according to claim 1 or 2, wherein the first circuitry is a processor.

4. Method according to any of claims 1-3, wherein the default value is not a valid data word.

5. Method according to any of claims 1-4, wherein the default value is written to the data bus after a specified maximum time after a data word was written to the data bus.

6. A memory module providing an interface for connecting a first circuitry, the interface being suitable for requesting data from the memory module and for providing data via a data bus to the first circuitry, wherein the time between a data request and the requested data being valid on the data bus is not predetermined, and wherein the memory module indicates the requested data being valid, the memory module comprising
- means for writing a default value on the data bus when the read data are not yet valid;
- means for writing the requested data on the data bus when the read data are valid;
- means for measuring a specified time or for triggering on a specified event; and
- means for writing the default value on the bus upon expiration of the specified time or upon triggering on the specified event.

7. Memory module according to claim 6, wherein the first circuitry is a processor.

8. Memory module according to claim 6 or 7, wherein the memory module comprises means for triggering on a specified event and means for measuring a specified time, and the means for writing the default value on the bus performs said writing at a specified time after triggering on a specified event.
